# EUROPEAN PATENT APPLICATION

(11) **EP 4 787 430 A1**
(43) Date of publication of application: **05.08.2026**
(21) Application number: 24871564.1
(22) Date of filing: 14.08.2024
(51) Int. Cl.: H01L 21/52, H01L 21/60, H10H 20/85

(54) **TRANSFER METHOD**

(30) Priority: 29.09.2023 JP 2023170164
(71) Applicant: SHIN-ETSU CHEMICAL CO., LTD., Tokyo 100-0005 (JP)
(72) Inventor: YAMAOKA, Hiroshi, Yokohama-shi, Kanagawa 234-0053 (JP); KIMURA, Shinji, Annaka-shi, Gunma 379-0224 (JP); OGAWA, Yoshinori, Tokyo 100-0005 (JP)
(74) Representative: Meissner Bolte Partnerschaft mbB
(86) International application number: PCT/JP2024/029001
(87) International publication number: WO 2025/069762

(57) **Abstract**

The present invention is a transfer method for transferring a plurality of microstructures arranged on a substrate to another substrate using laser irradiation, the method including the steps of transferring a first microstructure onto the other substrate by irradiating the first microstructure with a laser through the substrate, and further irradiating the first microstructure that has been transferred with a laser at least once. This provides a transfer method capable of removing the residue adhered to the microstructure while improving productivity.

## Description

### TECHNICAL FIELD

The present invention relates to a transfer method for transferring a plurality of microstructures arranged on a substrate to another substrate using laser irradiation.

### BACKGROUND ART

In recent years, nitride semiconductor optical devices have been increasingly used for backlights of liquid crystal displays and displays for signage. Since a large number of optical devices are used at a time for these applications, a high-throughput transfer technique has been desired. As a high-throughput transfer technique, batch transfer by a stamping method using a stamper has been generally performed, and transfer of 1,000 to tens of thousands of optical devices at a time has become possible.

A large number of optical devices are produced, for example, on a sapphire substrate by a semiconductor process. When producing a 4-inch display substrate with LEDs each having a 100 µm square or less, which is referred to as a micro-LED, millions of micro-LEDs are required. The micro-LED, which is a minute device of several tens of micrometers in size, is utilized after being separated from the sapphire substrate, which is an epitaxial substrate.

The typical separation method is performed by bonding a support substrate as a donor precursor substrate to optical devices arranged on the sapphire substrate and separating the optical devices from the sapphire substrate by laser lift-off. Thereby, it is possible to obtain the donor substrate having a surface on which a large number of optical devices are arranged.

Such a method is not limited to the methods related to the optical devices but is applicable to the production of the donor substrate having a surface on which a plurality of objects to be transferred, such as minute semiconductor devices, are arranged.

Moreover, the objects to be transferred on the donor substrate may be transferred, for example, to a receptor substrate such that these objects to be transferred are arranged corresponding to a circuit substrate of a product. Then, from this receptor substrate, the objects to be transferred may be transferred onto another substrate, such as the circuit substrate of the products, by the stamping method.

For example, Patent Document 1 proposes a method in which objects to be transferred on a donor substrate are accurately transferred onto a receptor substrate by using laser irradiation.

### CITATION LIST

### PATENT LITERATURE

Patent Document 1: JP 2000-4478 A

### SUMMARY OF INVENTION

### TECHNICAL PROBLEM

When transferring a plurality of microstructures that are provided on a substrate to another substrate by laser irradiation, residue may be generated on the microstructure that has been transferred and in the vicinity of the microstructure. This residue is considered to originate from a polymer material (resin, such as polyimide or rubber), such as an adhesive used to fix the microstructure to the substrate. Consequently, a problem arises in which the step of removing, such as wet etching (cleaning), is required after the transfer, which reduces productivity.

The present invention has been made to solve the above-described problem. An object of the present invention is to provide a transfer method capable of removing the residue adhered to the microstructure while improving productivity.

### SOLUTION TO PROBLEM

To achieve the object, the present invention provides a transfer method for transferring a plurality of microstructures arranged on a substrate to another substrate using laser irradiation, the method comprising the steps of:
transferring a first microstructure onto the other substrate by irradiating the first microstructure with a laser through the substrate; and
further irradiating the first microstructure that has been transferred with a laser at least once.

According to such a transfer method, by providing the step of further irradiating the transferred microstructure with the laser, the residue can be removed during the transfer of the microstructure, thereby enabling significant productivity improvement.

In this case, in the step of further irradiating, a second microstructure remaining on the substrate is irradiated together with the first microstructure that has been transferred with the laser, thereby enabling transferring the second microstructure onto the other substrate.

Accordingly, the productivity can be further improved.

In this case, the first microstructure and the second microstructure can be arranged adjacent to each other on the substrate.

With such microstructures arranged on the substrate, the transfer can be performed more efficiently.

In this case, a third microstructure remaining on the substrate, the first microstructure that has been transferred, and the second microstructure that has been transferred are further irradiated with the laser, thereby enabling transferring the third microstructure onto the other substrate.

Consequently, the residue can be removed more reliably, and productivity can also be improved.

In this case, the second microstructure and the third microstructure can be arranged adjacent to each other on the substrate.

With such microstructures arranged on the substrate, the transfer can be performed more efficiently.

In this case, the substrate and the other substrate can perform movement relative to each other in a predetermined direction, and can be irradiated with the laser in a stopped or a non-stopped state.

Accordingly, when the laser irradiation is performed in a state where movement is stopped, accuracy of both a laser irradiation position and a transfer position of the microstructure is improved. As a result, when the laser irradiation is performed in the non-stopped state, throughput can be further improved.

In this case, a shape of the irradiated laser is a rectangular shape, and the movement can be performed in a direction of a long side of the rectangle.

Accordingly, a degree of flexibility of both transfer and further irradiation treatments can be increased.

In this case, a length of a long side of the rectangular shape of the laser on an irradiation surface can be 3 times or more a length of the microstructure in a long side direction. Moreover, a length of a long side of the rectangular shape of the laser on an irradiation surface can be 5 times or more a length of the microstructure in a long side direction.

Accordingly, a degree of flexibility of both the transfer and further irradiation treatments can be further improved.

In this case, a plurality of the lasers having the rectangular shape can be provided and arranged spaced apart in a short side direction of the rectangle.

In this way, the treatment with higher productivity can be performed.

In this case, a plurality of the lasers having an irradiation shape on an irradiation surface substantially a same size as the microstructure can be provided, and the plurality of the lasers can be arranged spaced apart in the moving direction.

In this way, the treatment with improved accuracy can be performed.

In this case, a plurality of lasers is further provided spaced apart from the plurality of the lasers in a direction perpendicular to the moving direction and can be arranged in a matrix.

In this way, the treatment with higher productivity can be performed.

In this case, the plurality of microstructures can be arranged on the substrate via a polymer material.

In particular, in such a case, the removal of the residue can be reliably performed.

In this case, in the step of transferring, the microstructure arranged on the substrate can be transferred onto the other substrate by a single laser irradiation.

Accordingly, the microstructure can be transferred onto the other substrate more efficiently and reliably.

In this case, in the step of further irradiating, the microstructure that has been transferred can be irradiated with the laser a plurality of times.

Consequently, the residue can be effectively removed.

In this case, the microstructure that has been transferred can be irradiated a plurality of times with a laser having an energy density lower than that of the laser used to irradiate the microstructure in the step of transferring.

Consequently, debris generation from the residue can be more effectively suppressed.

In this case, a total energy density of the laser irradiated the plurality of times can be higher than the energy density of the laser irradiated onto the microstructure in the step of transferring.

Consequently, the residue can be removed more effectively.

In this case, an energy density of a laser irradiated onto the microstructure that has been transferred in the step of further irradiating can be lower than the energy density of the laser irradiated onto the microstructure in the step of transferring.

Consequently, the debris generation from the residue can be suppressed more effectively.

In this case, the plurality of microstructures arranged on the substrate and the other substrate can be in a spaced-apart state.

Consequently, the debris generation from the residue can be suppressed more effectively.

In this case, the laser irradiated onto the microstructure is shaped by passing through an opening of a photomask, and
a transmittance of the opening through which the laser irradiated onto the microstructure that has been transferred in the step of further irradiating can be lower than a transmittance of an opening through which the laser irradiated onto the microstructure arranged on the substrate in the step of transferring.

Consequently, the energy density of the laser irradiated onto the microstructure can be easily adjusted.

In this case, in the step of transferring, the laser can be irradiated in a state where the substrate and the other substrate are in contact, and
in the step of further irradiating, the laser can be irradiated in a state where the substrate and the other substrate are separated by forming a space therebetween.

Consequently, the microstructure can be transferred more accurately while significantly improving productivity.

In this case, in the step of further irradiating, oxygen gas can be supplied in the space between the substrate and the other substrate.

Consequently, the debris generation (generation of debris) during residue removal can be effectively reduced.

### ADVANTAGEOUS EFFECTS OF INVENTION

As described above, according to the inventive transfer method, by providing the step of further irradiating the microstructure that has been transferred with the laser, the residue can be removed during the transfer of the microstructure, thereby enabling a significant productivity improvement.

### BRIEF DESCRIPTION OF DRAWINGS

[FIG. 1] is a schematic view illustrating an example of a transfer method according to the present invention.
[FIG. 2] is a schematic view illustrating another example of a transfer method according to the present invention.
[FIG. 3] is a schematic view illustrating still another example of a transfer method according to the present invention.
[FIG. 4] is a schematic view illustrating states of a substrate and another substrate before transfer of a microstructure.
[FIG. 5] is a schematic view illustrating the first embodiment.
[FIG. 6] is a schematic view illustrating a step subsequent to that shown in FIG. 5.
[FIG. 7] is a schematic view illustrating a step subsequent to that shown in FIG. 6.
[FIG. 8] is a schematic view illustrating a step subsequent to that shown in FIG. 7.
[FIG. 9] is a schematic view illustrating a step subsequent to that shown in FIG. 8.
[FIG. 10] is a schematic view illustrating a step subsequent to that shown in FIG. 9.
[FIG. 11] is a schematic view illustrating states of a substrate and another substrate after transfer of a microstructure.
[FIG. 12] is a schematic view illustrating the second embodiment.
[FIG. 13] is a schematic view illustrating a step subsequent to that shown in FIG. 12.
[FIG. 14] is a schematic view illustrating a step subsequent to that shown in FIG. 13.
[FIG. 15] is a schematic view illustrating a step subsequent to that shown in FIG. 14.
[FIG. 16] is a schematic view illustrating a step subsequent to that shown in FIG. 15.
[FIG. 17] is a schematic view illustrating a step subsequent to that shown in FIG. 16.
[FIG. 18] is a schematic view illustrating an example of a transfer apparatus.
[FIG. 19] is a schematic view illustrating an example of a photomask.
[FIG. 20] is a schematic view illustrating another aspect of a transfer method according to the present invention.

### DESCRIPTION OF EMBODIMENTS

Hereinafter, the present invention will be described in detail. However, the present invention is not limited thereto.

As described above, a transfer method has been desired, in which residue adhered to a microstructure can be removed while improving productivity.

To solve the above problem, the present inventors have earnestly studied and found that by virtue of a transfer method for transferring a plurality of microstructures arranged on a substrate to another substrate using laser irradiation, in which the method includes the steps of transferring a first microstructure onto the other substrate by irradiating the first microstructure with a laser through the substrate, and further irradiating the first microstructure that has been transferred with a laser at least once, the residue can be removed during the transfer of the microstructure and productivity can be significantly improved by providing the step of further irradiating the microstructure that has been transferred. This finding has led to the completion of the present invention.

Hereinafter, the present invention will be described with reference to the drawings.

### [Transfer Method]

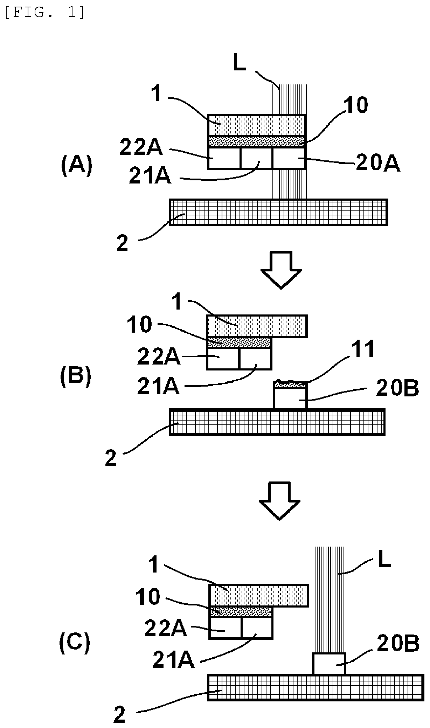

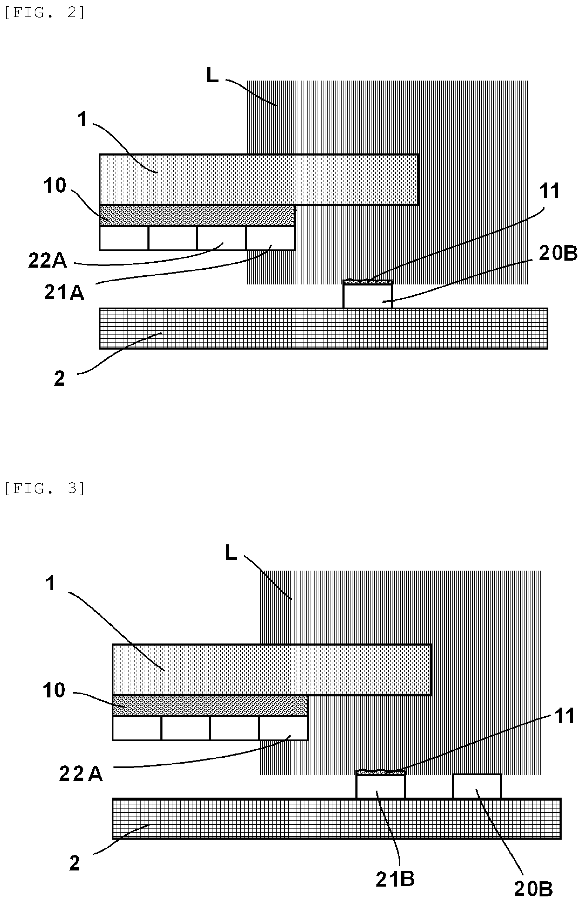

The present invention is a transfer method for transferring a plurality of microstructures arranged on a substrate to another substrate using laser irradiation. FIG. 1 shows an example of the inventive transfer method. As shown in FIG. 1, a substrate 1 is provided with a first microstructure 20A, a second microstructure 21A, and a third microstructure 22A. The present invention includes the step of transferring to transfer the first microstructure 20A onto another substrate 2 by irradiating the first microstructure 20A with a laser L through the substrate 1 (FIGs. 1 (A) and (B)), and the step of further irradiating to irradiate the first microstructure 20B that has been transferred with the laser L at least once (FIG. 1 (C)). The microstructure is fixed to the substrate 1 by a polymer material such as an adhesive 10, and the transfer can be performed, for example, by laser ablation of the polymer material through laser irradiation. After the step of transferring, residue 11 may be generated on the first microstructure 20B that has been transferred and around this microstructure. This residue is considered to originate from the polymer material(e.g., resin such as polyimide or rubber), such as the adhesive used to fix the microstructure to the substrate. After the step of transferring, the step of further irradiating is performed, in which the first microstructure 20B that has been transferred is irradiated with the laser L, and the residue 11 originating from the polymer material, or the like, which is adhered to the microstructure, can be removed. This removal of the residue can be achieved, for example, by laser ablation or by irradiating the residue with a laser at an energy density lower than that required to induce laser ablation. Since the step of transferring and the step of further irradiating can be performed during the transfer operation, productivity of the transfer operation can be significantly improved. In an example of FIG. 1, by moving the substrate 1 and the other substrate 2 relative to each other in parallel, a transfer position of the first microstructure onto the other substrate 2 is adjusted. Note that in FIG. 1, although the residue 11 is illustrated as having a thickness over the entire laser-irradiation surface of the microstructure, the residue 11 is not necessarily present in such a shape and may be present in a linear, spotted, or dot-like shape on a portion of the laser-irradiation surface. Moreover, in FIG. 1, the laser L merely schematically represents the size of an irradiation region and an irradiating direction, and, for example, FIG. 1 (A) does not necessarily indicate that the laser penetrates the microstructure 20A. The same applies to FIGs. 2 and 3.

Note that the upper limit of the number of irradiations with the laser L is not particularly limited in the step of further irradiating, but, for example, can be 100 times or less, 50 times or less, 30 times or less, 10 times or less, or 5 times or less.

FIG. 2 shows an aspect in which a plurality of microstructures are simultaneously irradiated with a laser. In an example of FIG. 2, the step of transferring and the step of further irradiating are performed in parallel. In the step of transferring, the second microstructure 21A, which has not been transferred, remaining on the substrate 1, is irradiated with a laser together with the first microstructure 20B, which has already been transferred, to transfer the second microstructure 21A onto the other substrate 2. In the step of further irradiating, the first microstructure 20B is further irradiated with the laser. In other words, with a single laser irradiation, both the second microstructure 21A remaining on the substrate 1 and the first microstructure 20B that has already been transferred are subjected to the laser irradiation. From a different perspective, the step of transferring for the second microstructure 21A can also serve as the step of further irradiating for the first microstructure 20B. When viewed from the laser irradiating process, the step of transferring and the step of further irradiating can be performed simultaneously by a laser irradiation treatment. Accordingly, the transfer of the microstructure can be performed more efficiently. In the example of FIG. 2 as well, by moving the substrate 1 and the other substrate 2 relative to each other in parallel, the transfer position of the first microstructure 20B onto the other substrate 2 is adjusted. For example, by moving the substrate 1 and the other substrate 2 in parallel in the same direction relative to the laser to be irradiated and by making the amount of displacement of the other substrate 2 larger than the amount of displacement of the substrate 1, a spacing between the microstructures transferred onto the other substrate 2 can be increased. Note that, as described above, in FIG. 2 as well, the laser L merely schematically represents the size of the irradiation region and the irradiating direction, and, for example, FIG. 2 does not necessarily indicate that the laser stops at the height of the surface of the microstructure 20B. The same applies to FIG. 3.

Note that it is preferable that the first microstructure 20A and the second microstructure 21A are arranged adjacent to each other on the substrate 1. With such microstructures on the substrate, the transfer and the removal of the residue 11 can be performed more efficiently.

FIG. 3 shows another aspect in which a plurality of microstructures are collectively irradiated with a laser. In an example shown in FIG. 3, the step of transferring and the step of further irradiating are performed in parallel. In the step of transferring, the third microstructure 22A, which has not been transferred, remaining on the substrate 1, is irradiated with a laser together with the first microstructure 20B and a second microstructure 21B, which have already been transferred onto the other substrate 2, to transfer the third microstructure 22A onto the other substrate 2. In the step of further irradiating, the first microstructure 20B and the second microstructure 21B are further irradiated with the laser. This enables more stable removal of the residue 11 and more efficient transfer of the microstructure, thereby enabling the improvement of the productivity. In the example in FIG. 3 as well, by moving the substrate 1 and the other substrate 2 relative to each other in parallel, the transfer positions of the first and second microstructures onto the other substrate 2 are adjusted.

Note that it is preferable that the second microstructure 21A and the third microstructure 22A are arranged adjacent to each other on the substrate 1. With such microstructures on the substrate, the transfer and removal of the residue can be performed more efficiently.

As in the aspects shown in FIGs. 1 to 3, it is preferable to move the substrate 1 and the other substrate 2 relative to each other in a predetermined direction. Moreover, the irradiation with the laser L may be performed in a state where the relative movement of the substrate 1 and the other substrate 2 is stopped or in a non-stopped state where the movement is maintained. When the irradiation of the laser L is performed in the state where the movement is stopped, the accuracy of the laser irradiation position and the transfer position of the microstructure is further improved. Alternatively, when the irradiation of the laser L is performed in the non-stopped state, the throughput can be further improved.

### (Microstructure)

The microstructure that is transferred by the inventive transfer method is not particularly limited. For example, a semiconductor device such as a micro-LED can be exemplified. The plurality of microstructures may be composed of microstructures provided on the substrate via the adhesive that includes the polymer material. In such cases, the removal of residue by employing the step of further irradiating according to the inventive transfer method is particularly effective. It is preferable to select an adhesive with low debris generation, even when subjected to the laser ablation. Moreover, in order to facilitate the removal of the residue, the thickness of the adhesive is preferably as thin as possible, more preferably 1 µm or less, particularly preferably 0.8 µm or less, and highly preferably 0.6 µm. From the viewpoint of providing a layer of the adhesive in a uniform manner and the viewpoint of adhesive strength, the preferred lower limit is about 0.2 µm.

### (Substrate)

The substrate 1 is not particularly limited as long as the microstructure can be provided. When the microstructure is the semiconductor device, for example, when the microstructure is transferred from the substrate on which the device has been formed to a donor substrate, then to a receptor substrate, finally to a circuit board of a product, the substrate 1 may be the substrate on which the device has been formed, the donor substrate, or the receptor substrate. Specifically, it is preferable that the substrate is transmissive to the irradiated laser, and more preferably, the substrate is a glass substrate such as synthetic quartz.

### (Another Substrate)

Another substrate 2 is also not particularly limited as long as the microstructure can be transferred thereon. When the microstructure is the semiconductor device, for example, when the microstructure is transferred from the substrate on which the device has been formed to a donor substrate, then to a receptor substrate, finally to a circuit board of a product, the other substrate 2 may be the donor substrate, the receptor substrate, or the circuit board. The other substrate is preferably provided with a layer for shock absorption and/or adhesion (e.g., PDMQ or solder paste) at the position where the microstructure is arranged. When the other substrate is the circuit board and the microstructure is electrically connected to the circuit board in a face-down method, the layer for shock absorption and/or adhesion is preferably a layer containing a conductive material. Examples of such conductive materials include isotropic conductive materials such as solder paste, and anisotropic conductive materials such as anisotropic conductive adhesive. Moreover, even in a face-up method, when an electrical connection is required, the conductive materials described above may be used.

### (Laser)

The laser L is not particularly limited and can be, for example, an excimer laser. A shape of the laser L irradiating the microstructure (shape of irradiation region of laser L) is not particularly limited as long as the transfer of the microstructure is enabled and the removal of the residue is enabled. The shape of the laser L (shape of irradiation region of laser L), which is subsequently described, can be appropriately formed, for example, by passing the laser through a photomask. Examples of the excimer lasers include an ArF excimer laser (wavelength of 193 nm), a KrF excimer laser (wavelength of 248 nm), a XeCl excimer laser (wavelength of 308 nm), and an XeF excimer laser (wavelength of 353 nm). From the viewpoint of a track record of use and availability, the KrF excimer laser is preferred.

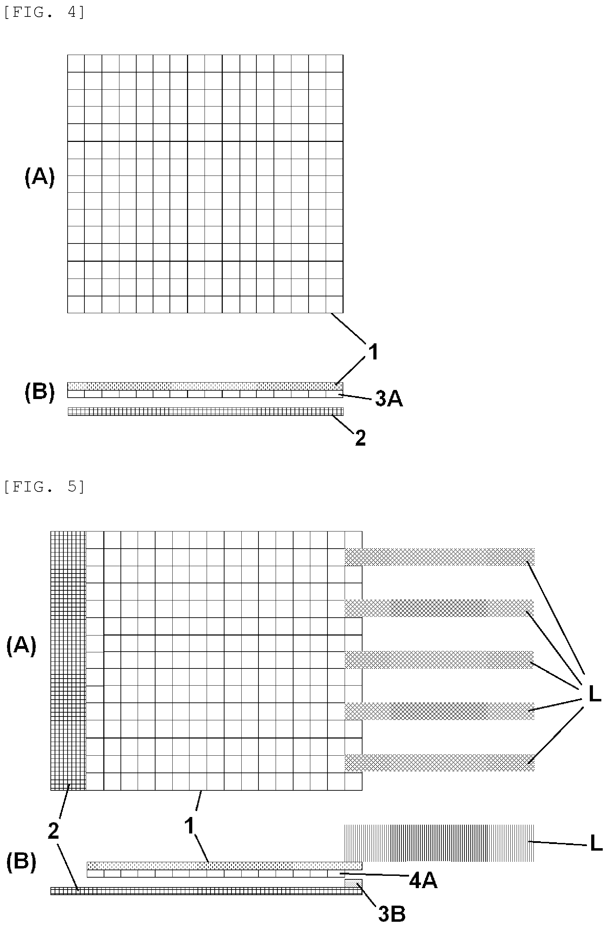

The shape of the laser L irradiated (shape of irradiation region of laser L) is not particularly limited. For example, the shape of the laser L irradiating the microstructure (shape of irradiation region of laser L) can be a rectangular shape. In this case, a long side direction of the rectangle is preferably a relative movement direction of the substrate 1 and the other substrate 2. Moreover, it is preferable that a plurality of lasers having a rectangular shape is provided and arranged spaced apart in a short side direction of the rectangle (see FIGs. 5 to 10). Such a laser irradiation region is less affected by constraints on an arrangement spacing (transfer pitch) of the microstructure on the other substrate 2, thereby increasing the degree of flexibility in the transfer and further irradiation treatments. When a plurality of microstructures can be subjected to the transfer and further irradiation treatments with a single laser irradiation, the productivity is further improved. Moreover, by forming a rectangular shape, the region between the microstructures on the other substrate can be irradiated with a laser, and the residue present in such a region is removed with ease. When the laser L has this shape, such a case will be described in detail with reference to FIGs 4 to 11 in the first embodiment described later.

Furthermore, the length of the rectangular shape that is the shape of the laser L in the long side direction is more preferably 3 times or more, and further preferably 5 times or more, a length of the microstructure in the long side direction. This enables the degree of flexibility of the transfer and further irradiation treatments to be more improved. The upper limit of a ratio of the length of the rectangular shape that is the shape of the laser L in the long side direction to the length of the microstructure in the long side direction is not particularly limited, but can be, for example, 100 times or less, 50 times or less, 30 times or less, or 10 times or less.

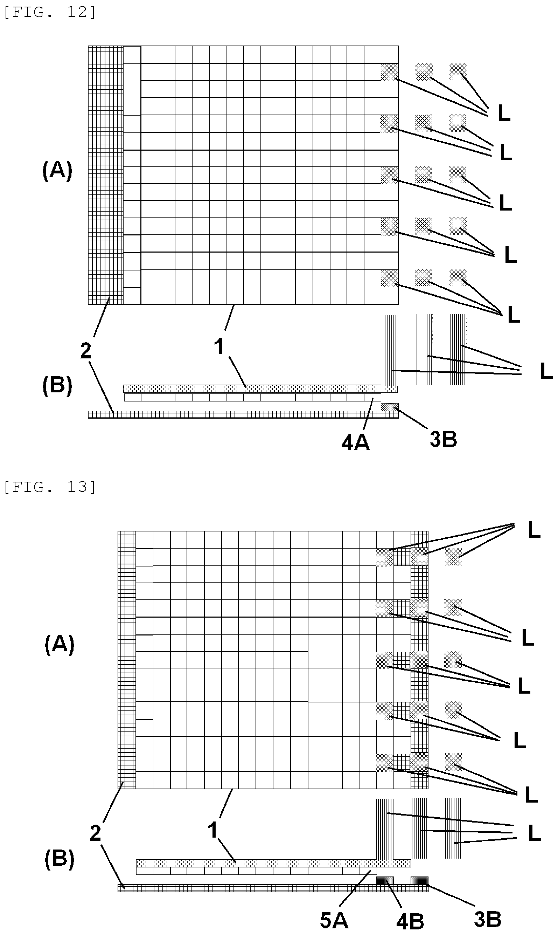

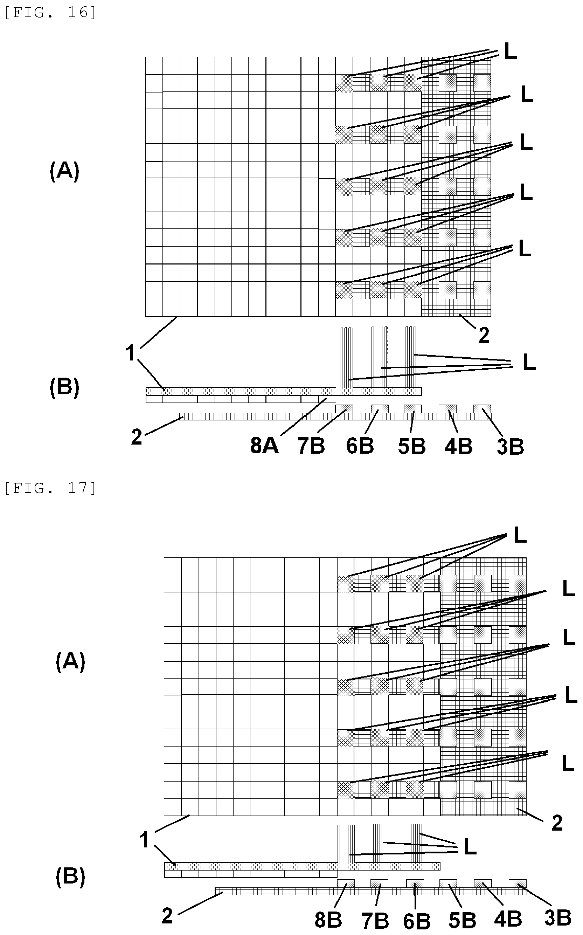

The shape of the laser L irradiating the microstructure (shape of irradiation region of laser L) may be configured such that a plurality of lasers have substantially the same size as the microstructure on the irradiation surface. In this case, an arrangement of laser irradiation regions is preferably configured such that a pitch thereof corresponds to N times (N: integer) an arrangement pitch of the microstructures arranged on the other substrate 2. The plurality of lasers is spaced apart in the relative movement direction of the substrate 1 and the other substrate 2. Moreover, with spacing apart from the above plurality of lasers, a plurality of lasers is preferably further provided in a direction perpendicular to the relative moving direction of the substrate 1 and the other substrate 2, and arranged in a matrix (see FIGs. 12 to 17). With such a laser irradiation region, the plurality of microstructures can be subjected to the transfer and further irradiation treatments with a single laser irradiation, thereby further improving the productivity. A case in which the laser L has such a shape will be described in detail, with reference to FIGs 12 to 17 in the second embodiment described later.

In the step of transferring, it is preferable that the microstructure arranged on the substrate 1 is transferred onto the other substrate 2 by a single laser irradiation. Consequently, in the step of transferring, the energy density of the laser irradiated onto the microstructure preferably has an energy density sufficient to laser-ablate the polymer material fixing the microstructure to the substrate in a single irradiation. Here, the laser ablation is generally understood as a phenomenon in which, when a surface of a solid or liquid is irradiated with laser light, plasma is generated, followed by an explosive release of a component material on the surface. Note that when the stable transfer can be achieved, the energy density need not necessarily be sufficient for the laser ablation.

In the step of further irradiating, it is preferable to irradiate the transferred microstructure with the laser a plurality of times. Through the plurality of laser irradiations, the residue can be more reliably removed, and the debris generation can be more effectively suppressed as well. In this case, in the step of further irradiating, the microstructure is preferably irradiated a plurality of times with a laser having an energy density lower than the energy density of the laser used to irradiate the microstructure in the step of transferring. When transferring, a relatively high energy density enables improving a positional accuracy of the transfer (transfer), while when further irradiating, the energy density lower than that of the irradiation for the transfer is expected to exhibit an effect to suppress the debris generation during the residue removal. Furthermore, the total energy density of the laser irradiated the plurality of times in the step of further irradiating may be higher than the energy density of the laser irradiated onto the microstructure in the step of transferring. This enables more effective removal of the residue.

Moreover, the energy density of the laser irradiated onto the microstructure that has been transferred in the step of further irradiating is not particularly limited. In the step of further irradiating, the energy density of the laser by single irradiation may be the same as that in the step of transferring, but is preferably lower than the energy density of the laser irradiated onto the microstructure in the step of transferring. For example, when the energy density of the laser irradiated onto the microstructure in the step of transferring is set to approximately 700 to 2000 mJ/cm², and the energy density of the irradiated laser in the step of further irradiating is set to approximately 30 to 300 mJ/cm², this enables more effective suppression of the debris generation of soot-like matter during the residue removal, and suppression of excessive laser irradiation on the other substrate. Here, the energy density of the single laser irradiation in the step of further irradiating is preferably lower than the energy density required for sufficient laser ablation of the polymer material. When the polymer material is laser-ablated, a portion of the polymer material may remain as soot-like carbon-based debris; consequently, it is preferable to reduce the energy density of the laser in a single irradiation to suppress the debris from remaining. Although the energy density of the single laser irradiation in the step of further irradiating may vary depending on a type of the polymer material and a wavelength of the laser to be irradiated, it can be selected based on changes in a surface roughness of the polymer material which is observed by a surface roughness meter when irradiating the polymer material with the laser with varing the energy density.

It is preferable that the plurality of microstructures arranged on the substrate 1 and the other substrate 2 are in a spaced-apart state. In such a state, air is present around the plurality of microstructures arranged on the substrate 1. Accordingly, when compared with a case in which the transfer and the residue removal by further irradiation are performed in a state where the plurality of microstructures arranged on the substrate 1 and the other substrate 2 are in contact, the polymer material and the residue of the polymer material are easily converted into carbon dioxide rather than the soot-like carbon-based debris by irradited with the laser. Accordingly, the debris generation can be more effectively suppressed.

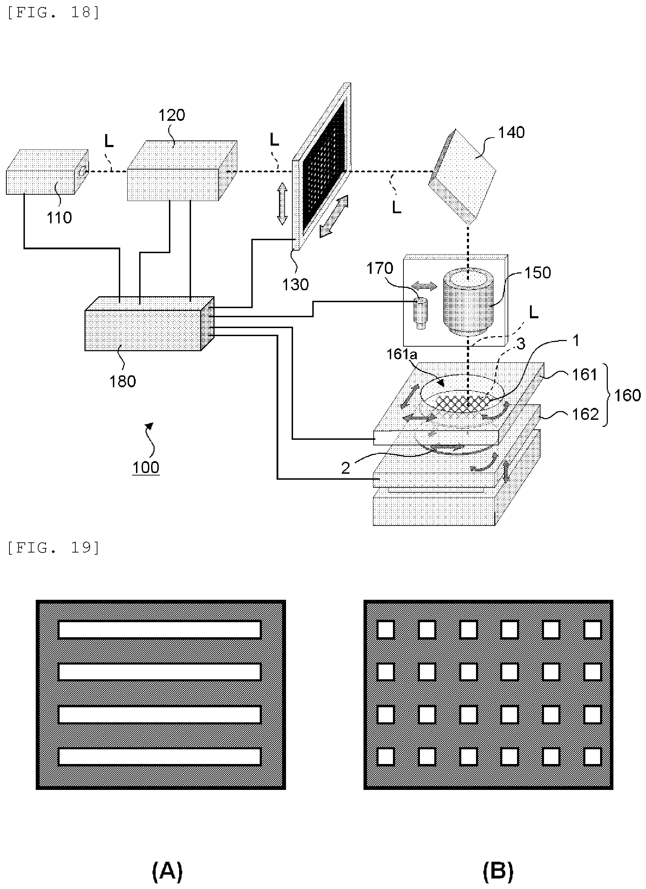

The laser irradiated onto the microstructure is preferably formed by passing through an opening of a photomask. FIG. 19 shows an example of a photomask. FIG. 19 (A) shows an example of a photomask for forming a rectangle-shaped laser, and FIG. 19 (B) shows an example of a photomask for forming a laser having a shape corresponding to that of a microstructure. Moreover, by setting a transmittance of the opening through which the microstructure transferred on the other substrate 2 is irradiated with the laser in the step of further irradiating to be lower than a transmittance of an opening through which the microstructure arranged on the substrate 1 is irradiated with the laser in the step of transferring, adjustment of the energy density of the laser L as described above can be easily performed. For example, a semitransparent film may be used as a shielding film in the opening of the photomask to vary the transmittance. It is preferable to increase the transmittance in the irradiated portion for the step of transferring to improve transfer position accuracy. Alternatively, it is preferable to decrease the transmittance in the irradiated portion for the step of further irradiating to suppress the debris generation during the residue removal.

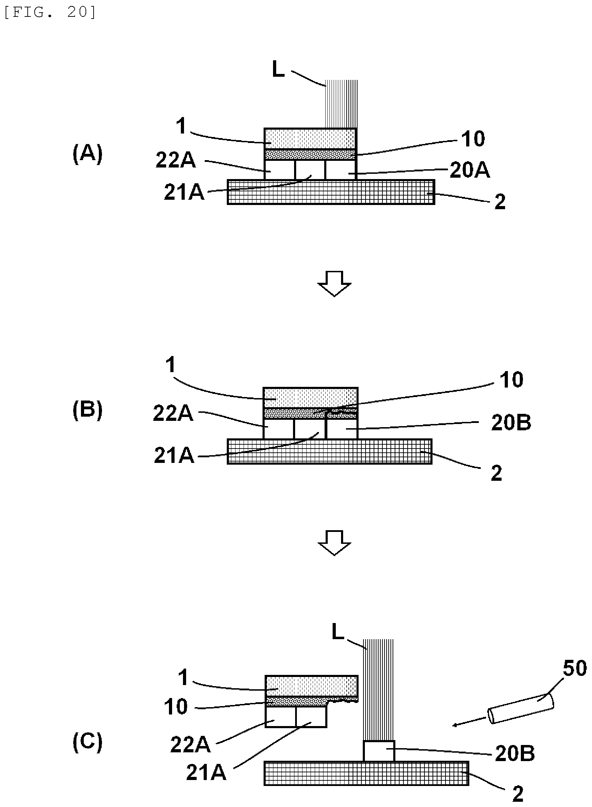

FIG. 20 shows another aspect of the inventive transfer method. The substrate 1 and the substrate 2 are placed on the respective substrate stages. Then, as shown in FIG. 20 (A), in a state where the substrate 1 provided with the first microstructure 20A, the second microstructure 21A and the third microstructure 22A, is in contact with the substrate 2, the first microstructure 20A is irradiated with the laser L throuth the substrate 1 to transfer the first microstructure 20A onto the other substrate 2 (FIG. 20 (B)). Thereafter, the substrate 1 and the substrate 2 are separated to form a space between the two substrates. Subsequently, in a state where the two substrates are spaced apart, the step of further irradiating is performed, in which the first microstructure 20B that has been transferred is irradiated with the laser L at least once (FIG. 20 (C)). These steps (FIGs. 20 (A) to (C)) are repeatedly performed. This enables highly accurate transfer while significantly improving productivity.

Moreover, in the step of further irradiating, as shown in FIG. 20 (C), by supplying oxygen-containing gas into at least the space between the substrate 1 and the substrate 2 using an oxygen gas supply means 50, or the like, an environment having a higher oxygen concentration than the atmosphere can be formed. As a result, the debris generation (generation of debris) during the residue removal can be effectively reduced.

Note that it is sufficient that the supply of the oxygen-containing gas ensures that at least the space between the substrate 1 and the substrate 2 in an environment having an oxygen concentration higher than that of the atmosphere. The entire space, including the substrate 1 and the substrate 2, may have a high oxygen concentration, or only the space between the substrate 1 and the substrate 2 may have a high oxygen concentration. Moreover, as the oxygen-containing gas, oxygen gas alone may be used, or diluted oxygen gas may be used. Furthermore, in FIG. 20, although the aspect of the laser irradiation is shown as the same as that in FIG. 1, it is to be understood that the aspects of the laser irradiation described in FIGs. 2 to 10, and 12 to 17 can be applied.

By repeating the transfer of the microstructure as described above, a large number of the microstructures can be transferred at a required pitch on a large-area microstructure receiving substrate (substrate 2). For example, when employing a semiconductor device as the microstructure, and when a device supply substrate (substrate 1) has a diameter of 4 inches (100 mm) and a device pitch of 6 µm, and a device receiving substrate (substrate 2) has dimensions of 300 mm × 350 mm and a pixel pitch of 90 µm, approximately 15 device receiving substrates can be produced from one device supply substrate.

The inventive transfer method can be applied to a LLO (Laser Lift Off) method or a LIFT (Laser Induced Forward Transfer) method.

### [Transfer Apparatus]

A transfer apparatus used for performing the inventive transfer method is not particularly limited as long as that is capable of irradiating an object to be transferred with the laser and of transferring the object to be transferred from the substrate to the other substrate. For example, a transfer apparatus such as shown in FIG. 18 can be employed. A transfer apparatus 100 exemplified in FIG. 18 is provided with a laser oscillator 110, a shaping optical system 120, a photomask 130, a folding mirror 140, a reduced projection lens 150, a stage 160, an alignment camera 170, a controller 180, and the like.

The stage 160 is configured with an upper stage 161 having an opening 161a and supporting the substrate 1, and a lower stage 162 supporting the other substrate 2. The stage 160 is configured to support the substrate 1, and the other substrate 2 facing each other, and these substrates can move individually.

The laser oscillator 110 is configured, for example, to oscillate the laser L in a pulsed manner. Each component of the transfer apparatus 100 is arranged such that the laser L oscillated from the laser oscillator 110 is shaped by passing through the shaping optical system 120, and further shaped by passing through the photomask 130, and then redirected in a traveling direction by the folding mirror 140, and further passes through the reduced projection lens 150, and then this laser 20 passes through the opening 161a of the upper stage 161, thereby forming an optical path reaching the substrate 1. Thus, a photomask 130 is arranged on the optical path connecting the laser oscillator 110 and the stage 160.

Furthermore, in the transfer apparatus 100 shown in FIG. 18, the laser oscillator 110, the photomask 130, and the stage 160 (upper stage 161 and lower stage 162) are configured to enable irradiating collectively on a plurality of microstructures 3 with the laser L from the laser oscillator 110. The controller 180 is configured to enable controlling the transfer apparatus 100 such that the inventive transfer method as described later is performed. Note that the other detailed configuration of the transfer apparatus and operational method can be performed with reference to, for example, WO 2019/244362 A1.

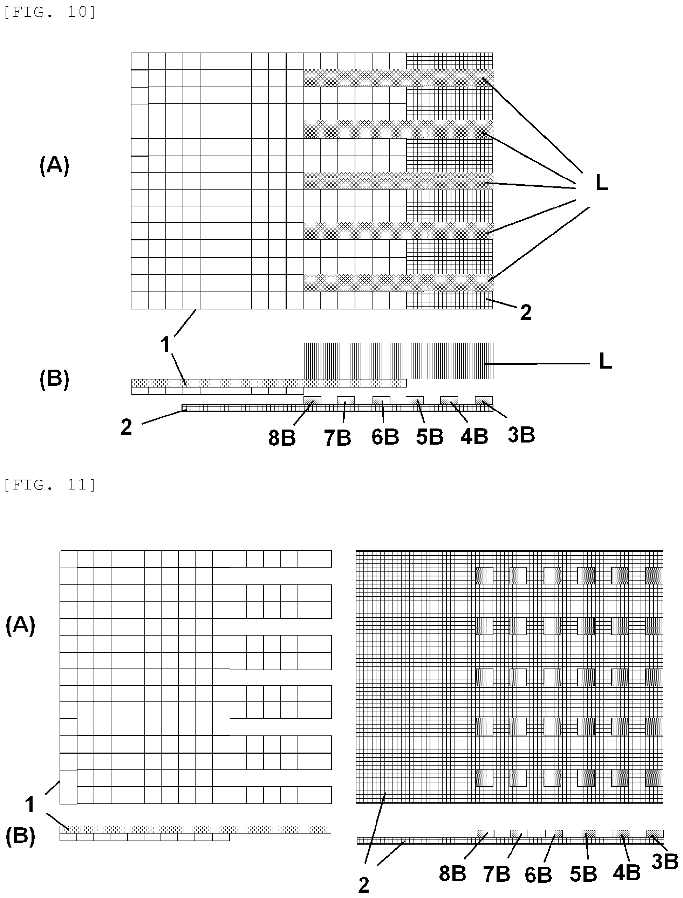

Based on the above description, the inventive transfer method will be more specifically described using FIGs. 4 to 17. In each of FIGs. 4 to 17, (A) shows a view from the laser irradiation direction (back surface side of substrate), and (B) shows a view from the side with respect to the laser irradiation direction. FIGs. 4 and 11 are common to the first and the second embodiments described below, and FIG. 4 shows the substrate 1 and the other substrate 2 before the transfer of a first microstructure 3A, and FIG. 11 shows the substrate 1 and the other substrate 2 after the transfer of a plurality of microstructures (3B to 8B). As shown in FIG. 4, a plurality of microstructures is provided adjacent to each other on the substrate 1 before transfer. A surface of the substrate 1 on which the plurality of microstructures is provided, and a surface of the other substrate 2 on which the microstructures are to be transferred are faced to each other, and then the microstructures are transferred by irradiating with the laser L from the side of the substrate 1 surface on which the microstructures are not provided. Then, after the transfer, as shown in FIG. 11, the plurality of microstructures (3B to 8B) is transferred to the desired positions on the other substrate 2.

### [First Embodiment]

FIGs. 5 to 10 show the first embodiment of the inventive transfer method. The first embodiment is an example in which, when transferring a plurality of microstructures provided on a substrate 1 to another substrate 2, the shape of the laser L irradiating to the microstructure (shape of irradiation region of laser L) is a rectangular shape, and the laser irradiation arranged in a plurality of lines spaced apart along a short side direction of a rectangle, is performed. Here, the lasers in the plurality of lines can be spaced apart, for example, at a pitch that is N times (N: integer) of an arrangement pitch of the microstructures on the substrate 1. In this embodiment, the example of 3 times is shown.

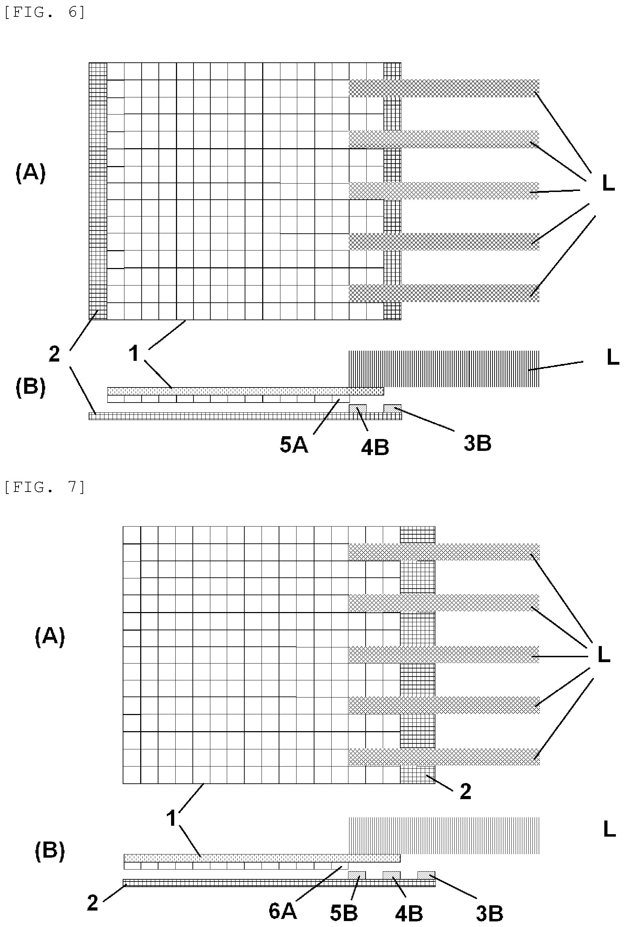

First, as shown in FIG. 5, only microstructures on the substrate 1 in the first row from the right side are irradiated with the laser and transferred onto the other substrate 2 as microstructures 3B (a plurality of microstructures 3B are present in a depth direction in FIG. 5(B)). At this time, residue (not shown) may be adhered to the microstructure 3B. Note that, as described above, also shown in FIG. 5, the laser L merely schematically represents the size of an irradiation region and an irradiating direction, and, for example, FIG. 5 does not necessarily indicate that the laser stops at the height of a back surface of the substrate 1 (surface where microstructure is not provided). The same applies to FIGs. 6 to 10, and 12 to 17.

Next, as shown in FIG. 6, the substrate 1 and the other substrate 2 are moved relative to each other in parallel. Then, microstructures 4A on the substrate 1 in a second row from the right side (see FIG. 5) are irradiated with the laser and transferred onto the other substrate 2 as microstructures 4B. At this time, the microstructures 3B that have already been transferred onto the other substrate 2 are also irradiated with the laser, thereby removing the residue on the microstructures 3B. Note that the residue on the microstructures 3B may remain after this irradiation, and the remained residue can be removed by subsequent further irradiation with the laser. In this embodiment, by setting the movement speed of the other substrate 2 twice relative to that of the substrate 1, the spacing between the microstructures transferred onto the other substrate 2 is increased.

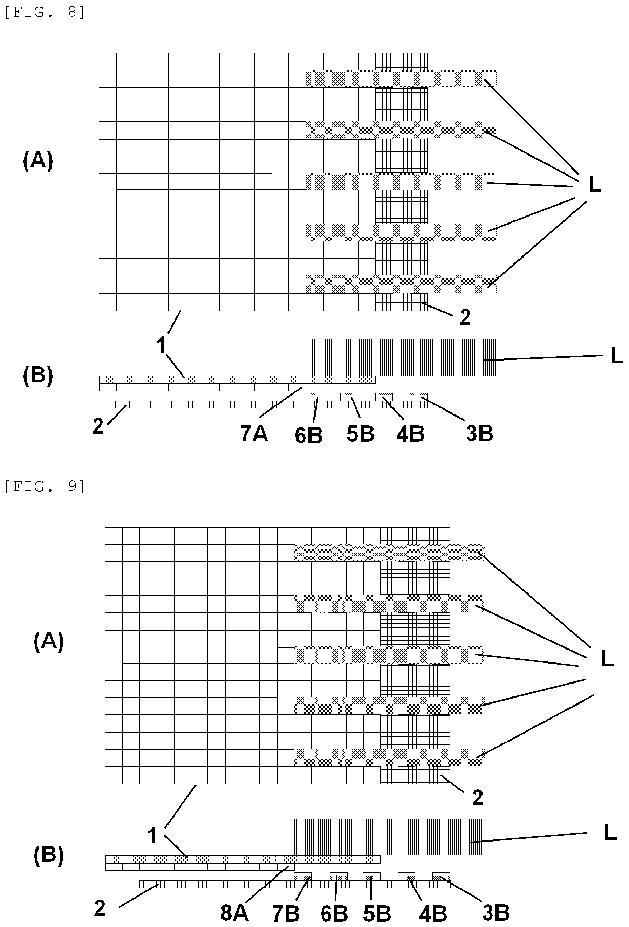

Next, as shown in FIG. 7, the substrate 1 and the other substrate 2 are moved relative to each other in parallel. Then, microstructures 5A on the substrate 1 in a third row from the right side (see FIG. 6) are irradiated with the laser and transferred onto the other substrate 2 as microstructures 5B. At this time, the microstructures 3B and 4B that have already been transferred onto the other substrate 2 are also irradiated with the laser, thereby removing the residue on the microstructures 3B and 4B. Such parallel movements of the substrate 1 and the other substrate 2, and the laser irradiations are further repeated (FIGs. 8 to 10); accordingly, microstructures 6A, 7A, and 8A provided on the substrate 1 are transferred onto the other substrate 2, and the other substrate 2 on which the microstructures 3B, 4B, 5B, 6B, 7B, and 8B have been transferred can be obtained. Moreover, the microstructures 3B, 4B, 5B, 6B, 7B, and 8B transferred onto the other substrate 2 are subjected to further irradiation with the laser at least once after the transfer, and thus, the residue is removed or reduced.

### [Second Embodiment]

FIGs. 12 to 17 show the second embodiment of the inventive transfer method. The second embodiment is an example in which, when transferring a plurality of microstructures provided on a substrate 1 to another substrate 2, a shape of laser L irradiating the microstructure (shape of irradiation region of laser L) has substantially the same size as the microstructure, and by arranging a plurality of such lasers in a matrix, a plurality of positions correnspoindg to the microstructures before and after the transfer is irradiated.

First, as shown in FIG. 12, only microstructures on the substrate 1 in the first row from a right side are irradiated with a laser and transferred onto the other substrate 2 as microstructures 3B (a plurality of microstructures are present in a depth direction in FIG. 12 (B)). At this time, residue (not shown) may be adhered to the microstructure 3B.

Next, as shown in FIG. 13, the substrate 1 and the other substrate 2 are moved relative to each other in parallel. Then, microstructures 4A on the substrate 1 in a second row from the right side (see FIG. 12) are irradiated with the laser and transferred onto the other substrate 2 as microstructures 4B. At this time, the microstructures 3B that have already been transferred onto the other substrate 2 are also irradiated with the laser having substantially the same shape as the microstructures, thereby removing the residue on the microstructures 3B. Note that when the microstructures 3B are subjected to subsequent laser irradiation, the residue on the microstructure 3B may remain thereon.

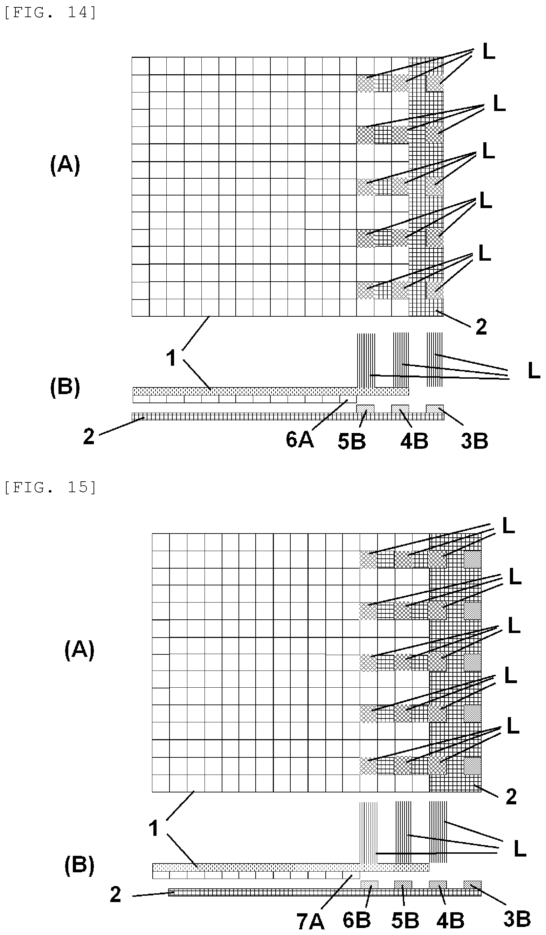

Next, as shown in FIG. 14, the substrate 1 and the other substrate 2 are moved relative to each other in parallel. Then, microstructures 5A on the substrate 1 in a third row from the right side (see FIG. 13) are irradiated with the laser and transferred onto the other substrate 2 as microstructures 5B. At this time, the microstructures 3B and 4B that have already been transferred onto the other substrate 2 are also irradiated with the laser, thereby removing the residue on the microstructures 3B and 4B. Such parallel movements of the substrate 1 and the other substrate 2, and the laser irradiations are further repeated (FIGs. 15 to 17); accordingly, microstructures 5A, 6A, 7A, and 8A provided on the substrate 1 are transferred onto the other substrate 2, and the other substrate 2 on which the microstructures 3B, 4B, 5B, 6B, 7B, and 8B have been transferred can be obtained. Moreover, the microstructures 3B, 4B, 5B, 6B, 7B, and 8B transferred onto the other substrate 2 are subjected to the further irradiation with the laser at least once after the transfer, and thus, the residue is removed or reduced.

With the inventive transfer method, the residue on the microstructure can be efficiently removed; therefore, the productivity of the transfer can be improved.

The present description includes the following embodiments.
[1]: A transfer method for transferring a plurality of microstructures arranged on a substrate to another substrate using laser irradiation, the method comprising the steps of:
   transferring a first microstructure onto the other substrate by irradiating the first microstructure with a laser through the substrate; and
   further irradiating the first microstructure that has been transferred with a laser at least once.
[2]: The transfer method of the above [1], wherein
   in the step of further irradiating, a second microstructure remaining on the substrate is irradiated together with the first microstructure that has been transferred with the laser, thereby transferring the second microstructure onto the other substrate.
[3]: The transfer method of the above [2], wherein
   the first microstructure and the second microstructure are arranged adjacent to each other on the substrate.
[4]: The transfer method of the above [2] or [3], wherein
   a third microstructure remaining on the substrate, the first microstructure that has been transferred, and the second microstructure that has been transferred are further irradiated with the laser, thereby transferring the third microstructure onto the other substrate.
[5]: The transfer method of the above [4], wherein
   the second microstructure and the third microstructure are arranged adjacent to each other on the substrate.
[6]: The transfer method of the above [1], [2], [3], [4], or [5], wherein
   the substrate and the other substrate perform movement relative to each other in a predetermined direction, and are irradiated with the laser in a stopped or a non-stopped state.
[7]: The transfer method of the above [1], [2], [3], [4], [5], or [6], wherein
   a shape of the irradiated laser is a rectangular shape, and the movement is performed in a direction of a long side of the rectangle.
[8]: The transfer method of the above [7], wherein
   a length of a long side of the rectangular shape of the laser on an irradiation surface is 3 times or more a length of the microstructure in a long side direction.
[9]: The transfer method of the above [7] or [8], wherein
   a length of a long side of the rectangular shape of the laser on an irradiation surface is 5 times or more a length of the microstructure in a long side direction.
[10]: The transfer method of the above [7], [8], or [9], wherein
   a plurality of the lasers having the rectangular shape is provided and arranged spaced apart in a short side direction of the rectangle.
[11]: The transfer method of the above [1], [2], [3], [4], [5], or [6], wherein
   a plurality of the lasers having an irradiation shape on an irradiation surface substantially a same size as the microstructure is provided, and the plurality of the lasers is arranged spaced apart in the moving direction.
[12]: The transfer method of the above [11], wherein
   a plurality of lasers is further provided spaced apart from the plurality of the lasers in a direction perpendicular to the moving direction and is arranged in a matrix.
[13]: The transfer method of the above [1], [2], [3], [4], [5], [6], [7], [8], [9], [10], [11], or [12], wherein
   the plurality of microstructures is arranged on the substrate via a polymer material.
[14]: The transfer method of the above [1], [2], [3], [4], [5], [6], [7], [8], [9], [10], [11], [12], or [13], wherein
   in the step of transferring, the microstructure arranged on the substrate is transferred onto the other substrate by a single laser irradiation.
[15]: The transfer method of the above [1], [2], [3], [4], [5], [6], [7], [8], [9], [10], [11], [12], [13], or [14], wherein
   in the step of further irradiating, the microstructure that has been transferred is irradiated with the laser a plurality of times.
[16]: The transfer method of the above [15], wherein
   the microstructure that has been transferred is irradiated a plurality of times with a laser having an energy density lower than that of the laser used to irradiate the microstructure in the step of transferring.
[17]: The transfer method of the above [15] or [16], wherein
   a total energy density of the laser irradiated the plurality of times is higher than the energy density of the laser irradiated onto the microstructure in the step of transferring.
[18]: The transfer method of the above [1], [2], [3], [4], [5], [6], [7], [8], [9], [10], [11], [12], [13], [14], [15], [16], or [17], wherein
   an energy density of a laser irradiated onto the microstructure that has been transferred in the step of further irradiating is lower than the energy density of the laser irradiated onto the microstructure in the step of transferring.
[19]: The transfer method of the above [1], [2], [3], [4], [5], [6], [7], [8], [9], [10], [11], [12], [13], [14], [15], [16], [17], or [18], wherein
   the plurality of microstructures arranged on the substrate and the other substrate are in a spaced-apart state.
[20]: The transfer method of the above [1], [2], [3], [4], [5], [6], [7], [8], [9], [10], [11], [12], [13], [14], [15], [16], [17], [18], or [19], wherein
   the laser irradiated onto the microstructure is shaped by passing through an opening of a photomask, and
   a transmittance of the opening through which the laser irradiated onto the microstructure that has been transferred in the step of further irradiating is lower than a transmittance of an opening through which the laser irradiated onto the microstructure arranged on the substrate in the step of transferring.
[21]: The transfer method of the above [1], [2], [3], [4], [5], [6], [7], [8], [9], [10], [11], [12], [13], [14], [15], [16], [17], [18], [19], or [20], wherein
   in the step of transferring, the laser is irradiated in a state where the substrate and the other substrate are in contact, and
   in the step of further irradiating, the laser is irradiated in a state where the substrate and the other substrate are separated by forming a space therebetween.
[22]: The transfer method of the above [21], wherein
   in the step of further irradiating, oxygen gas is supplied in the space between the substrate and the other substrate.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A transfer method for transferring a plurality of microstructures arranged on a substrate to another substrate using laser irradiation, the method comprising the steps of:
transferring a first microstructure onto the other substrate by irradiating the first microstructure with a laser through the substrate; and
further irradiating the first microstructure that has been transferred with a laser at least once.

2. The transfer method according to claim 1, wherein
in the step of further irradiating, a second microstructure remaining on the substrate is irradiated together with the first microstructure that has been transferred with the laser, thereby transferring the second microstructure onto the other substrate.

3. The transfer method according to claim 2, wherein
the first microstructure and the second microstructure are arranged adjacent to each other on the substrate.

4. The transfer method according to claim 2 or 3, wherein
a third microstructure remaining on the substrate, the first microstructure that has been transferred, and the second microstructure that has been transferred are further irradiated with the laser, thereby transferring the third microstructure onto the other substrate.

5. The transfer method according to claim 4, wherein
the second microstructure and the third microstructure are arranged adjacent to each other on the substrate.

6. The transfer method according to claim 1, wherein
the substrate and the other substrate perform movement relative to each other in a predetermined direction, and are irradiated with the laser in a stopped or a non-stopped state.

7. The transfer method according to claim 6, wherein
a shape of the irradiated laser is a rectangular shape, and the movement is performed in a direction of a long side of the rectangle.

8. The transfer method according to claim 7, wherein
a length of a long side of the rectangular shape of the laser on an irradiation surface is 3 times or more a length of the microstructure in a long side direction.

9. The transfer method according to claim 7, wherein
a length of a long side of the rectangular shape of the laser on an irradiation surface is 5 times or more a length of the microstructure in a long side direction.

10. The transfer method according to any one of claims 7 to 9, wherein
a plurality of the lasers having the rectangular shape is provided and arranged spaced apart in a short side direction of the rectangle.

11. The transfer method according to claim 6, wherein
a plurality of the lasers having an irradiation shape on an irradiation surface substantially a same size as the microstructure is provided, and the plurality of the lasers is arranged spaced apart in the moving direction.

12. The transfer method according to claim 11, wherein
a plurality of lasers is further provided spaced apart from the plurality of the lasers in a direction perpendicular to the moving direction and is arranged in a matrix.

13. The transfer method according to claim 1, wherein
the plurality of microstructures is arranged on the substrate via a polymer material.

14. The transfer method according to claim 1, wherein
in the step of transferring, the microstructure arranged on the substrate is transferred onto the other substrate by a single laser irradiation.

15. The transfer method according to claim 1, wherein
in the step of further irradiating, the microstructure that has been transferred is irradiated with the laser a plurality of times.

16. The transfer method according to claim 15, wherein
the microstructure that has been transferred is irradiated a plurality of times with a laser having an energy density lower than that of the laser used to irradiate the microstructure in the step of transferring.

17. The transfer method according to claim 16, wherein
a total energy density of the laser irradiated the plurality of times is higher than the energy density of the laser irradiated onto the microstructure in the step of transferring.

18. The transfer method according to claim 1, wherein
an energy density of a laser irradiated onto the microstructure that has been transferred in the step of further irradiating is lower than the energy density of the laser irradiated onto the microstructure in the step of transferring.

19. The transfer method according to claim 1, wherein
the plurality of microstructures arranged on the substrate and the other substrate are in a spaced-apart state.

20. The transfer method according to claim 1, wherein
the laser irradiated onto the microstructure is shaped by passing through an opening of a photomask, and
a transmittance of the opening through which the laser irradiated onto the microstructure that has been transferred in the step of further irradiating is lower than a transmittance of an opening through which the laser irradiated onto the microstructure arranged on the substrate in the step of transferring.

21. The transfer method according to claim 1, wherein
in the step of transferring, the laser is irradiated in a state where the substrate and the other substrate are in contact, and
in the step of further irradiating, the laser is irradiated in a state where the substrate and the other substrate are separated by forming a space therebetween.

22. The transfer method according to claim 21, wherein
in the step of further irradiating, oxygen gas is supplied in the space between the substrate and the other substrate.
